Europäisches Patentamt

European Patent Office

Office européen des brevets

(11) Publication number: **0 047 534**
**B1**

## (12) EUROPEAN PATENT SPECIFICATION

(45) Date of publication of patent specification: **10.10.84**

(21) Application number: **81107623.1**

(22) Date of filing: **01.02.80**

(60) Publication number of the earlier application in accordance with Art. 76 EPC: **0 014 444**

(51) Int. Cl.³: **B 32 B 31/12**

(54) Process for producing insulating laminates.

(30) Priority: **02.02.79 JP 11780/79**

(43) Date of publication of application:
**17.03.82 Bulletin 82/11**

(45) Publication of the grant of the patent:
**10.10.84 Bulletin 84/41**

(84) Designated Contracting States:
**BE DE FR GB IT NL**

(56) References cited:
**EP-A-0 014 444**
**GB-A- 743 900**
**GB-A- 950 704**
**US-A-4 012 267**

(73) Proprietor: **KANEGAFUCHI KAGAKU KOGYO KABUSHIKI KAISHA**
**2-4 Nakanoshima 3-chome**
**Kita-ku Osaka-shi (JP)**

(72) Inventor: **Oizumi, Masayuki**
**2-34, Yoshida-cho 1-chome**
**Hyogo-ku Kobe city Hyogoa (JP)**
Inventor: **Goto, Masana**
**4-23, Suehiro 3-chome**
**Miki city Hyogo (JP)**
Inventor: **Ishiki, Minoru**
**2-29, Yoshida-cho 1-chome**
**Hyogo-ku Kobe city Hyogo (JP)**
Inventor: **Uozumi, Shoji**
**2-25, Yoshida-cho 1-chome**
**Hyogo-ku Kobe city Hyogo (JP)**

(74) Representative: **Patentanwälte TER MEER - MÜLLER - STEINMEISTER**
**Triftstrasse 4**
**D-8000 München 22 (DE)**

EP 0 047 534 B1

# Description

## Background of the invention

The invention of this application relates to a process for producing insulating laminates for electric use or metal clad laminates for producing electric printed circuits.

'Insulating laminates' in this application means laminates to be used as basic boards or supporting boards to mount electric components or parts, and metal clad laminates means boards for producing electric printed circuits to equip electric components. Usually laminates are manufactured by impregnating a varnish of a thermosetting resin into a reinforcement or reinforcing material such as phenolic resin into paper, epoxy resin into paper or epoxy resin into glass cloth, producing prepregs from the resin-impregnated reinforcement, laminating the prepregs or prepregs and metalic foil, for example electrolytic copper coil, on one or both sides of the laminated prepregs, and hardening them by pressing and heating.

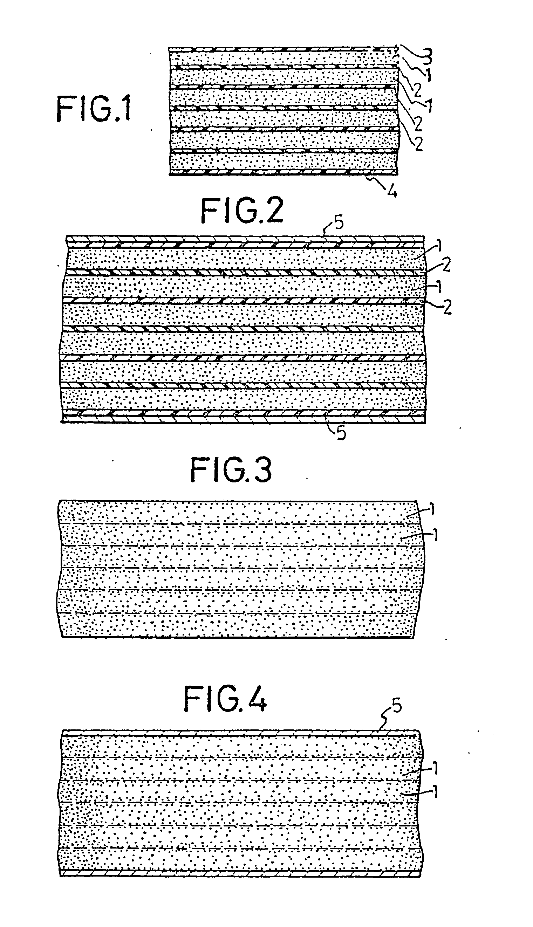

Conventional insulating laminates for electric use for example insulating laminates containing phenolic resin and paper manufactured as described above have the construction as illustrated in Fig. 3. Conventional metal clad laminates usually have a cross section similar to that shown in Fig. 4. Precise examinations have shown that the plural layers of paper of the laminates, which are impregnated with the resin are not isolated from each other because of an entanglement of fibres between each of the layers 1. It is well known that the electric insulation, the heat resistance and the stability of dimension of insulating laminates for electric use and metal clad laminates for printed circuit boards are apt to be harmed when the laminates are exposed to moisture or absorb water, which leads to unfavorable results in practical use. Usually water soaks from a surface layer into the laminates, which is facilitated by the fibers of the paper which constructing the laminates and by the boundary area between fiber and resin.

The electric insulating resistances are compared in humid atmosphere in the following two cases: (1) the surface of laminates as shown in Fig. 3 where paper fibers appear on the surface and, (2) the surface of laminates as shown in Fig. 4 where the surface thereof is covered with a layer of adhesive for the metal foil 5 or a layer of the same resin which is impregnating the reinforcement 1. The electric resistance of the former laminates (1) exhibits a remarkable decrease in comparison with that of the latter laminates (2). The test teaches that fibres of paper contribute to the decrease in insulating resistance, which is a main effect of water soaking into the surface layer of laminates.

The laminates as shown in Fig. 4 are manufactured by a process as disclosed in the Japanese unexamined patent specification SHO. 48—31265. The characteristics of the laminates as shown in Fig. 4 in humid atmosphere are to a certain extent improved and the soaking of water is temporarily prevented. However said laminates do not settle the problem satisfactorily because the resin layer is provided only at the surface, and the water having passed through the resin layer easily soaks into the laminate.

Therefore once water has entered the surface layer, conventional laminates, as illustrated in Figs. 3 and 4, easily permit the soaking of water into the inner portion of the laminate along continuous fibers extending from the surface to the inner portion of the laminate. Laminates having a construction as that of conventional laminates are apt to absorb moisture and water, which remarkably decreases the electric insulation properties, especially the ratio of electric volume resistance and ratio of electric isolating resistance as defined by the Japanese industrial standard JIS—C—6418. The absorbed moisture harms heat resistance necessary to endure the heat of solder, and in the case of metal clad insulating laminates for printed circuit the moisture absorbed in the reinforcement swells the laminates, lessens the stability of dimension and leads to a warping of the laminates.

US—A—4 012 267 discloses a process for continuously producing clad composites wherein the cladding is combined with a resin-wet reinforcement and pultruded through a forming and curing die in a single processing step. According to this process continuous length of a fibrous material are impregnated with a contracting liquid resin, piled up and passed through a die, wherein the pile is subjected to high pressures and high temperatures to cure said curable resin. Because of the high pressure and the fact that the resin is a contracting resin, the fibres of the different reinforcement layers are adjacent and in contact with each other.

GB—A—743 900 describes a method of making a laminated material which comprises superimposing a number of sheets of vulcanised fibre with adjacent sheets laid cross-grained and with a thin layer of coating of an adhesive between adjacent sheets and subjecting the pack of sheets to pressure to bond them into a single sheet or block. When a paper base sheet is used this sheet may be impregnated with a thermoplastic resin, whereas in the other case vulcanised fibres are used. Therefore this laminate comprises in any case a thermoplastic compound and is produced using high pressure, so that the fibres of the adjacent sheets will come into contact with each other again.

Subject matter of the present invention is a process for producing insulating laminates and metal clad laminates for electric use by laminating a plurality of reinforcements impregnated with a curable resin which is characterized by impregnating each of said reinforcements with a liquid curable resin without using a solvent and applying the same liquid curable resin to the surface of the impregnated reinforcements or impregnating each of said reinforcements with excessive liquid curable resin; forming a piled body of said reinforcements; passing the piled body through a slit device to control the quantity of resin existing between the layers of reinforcements; and curing the laminate; thereby providing a laminate comprising layers of cured resin existing between and extending substantially over the reinforcements.

Brief description of the drawings
Fig. 1 is a sectional view of an insulating laminate produced in accordance to the invention.
Fig. 2 is a sectional view of a metal clad laminate produced in accordance with the invention.
Figs. 3 and 4 are sectional views of prior art laminates, wherein Fig. 3 shows an insulating laminate and Fig. 4 shows a metal clad laminate.

Detailed description of the invention
The laminates obtained according to the present invention have a sectional view as shown in Fig. 1. Several layers of reinforcement 1 impregnated with a curable resin such as a thermosetting resin are laminated. Between each layer of reinforcement, there is a layer 2 of cured resin which is the same kind of resin as that which is impregnating the reinforcement 1. The outer surfaces of the outmost reinforcements are provided with surface layers 3 and 4 of cured resin. As the reinforcements 1 are isolated from each other by the layers 2 of cured resin, which is located and spread between the reinforcements 1, water or moisture is prevented to soak deep into the reinforcements 1 by the layer 2 of resin which is located between the first and second reinforcement. In the same manner the soaking of water into the inner portion of the reinforcements is prevented by each of the layers 2 of resin.

In the laminate obtained with the process of this invention, the soaking of water into the reinforcement 1 is decreased for the above mentioned reason, and the degradation of the characteristics of the laminate caused by soaked moisture and water is considerably reduced.

The curable resin used for impregnating the reinforcements 1 and for the layers 2 of cured resin formed between each reinforcement 1 are conventional known curable resins such as epoxy or unsaturated polyester resins, etc. The epoxy resin or the unsaturated polyester resin is recommended because those resins do not need pressure for forming layers of resin. When such a resin is used, the pressure is controlled not for the purpose of molding laminates but for controlling the thickness of the resin layers between the reinforcements 1. The same kind of resin is used throughout all layers 2. The resin throughout all layers 2 and the resin impregnating the reinforcement 1 is the same.

The reinforcements 1 are made from linter paper of kraft paper containing predominantly cellulose fibers, woven glass cloth, or woven asbestos cloth. Because of its low cost, paper is especially preferred as reinforcing material. Because paper is the material which is predominantly apt to soak moisture, a remarkable improvement of the insulating character of laminates can be obtained with this invention.

Since the resin used is liquid at room temperature, such as expoxy or unsaturated polyester resins, the laminates are manufactured by applying the resin to each resin-impregnated reinforcement at the time the reinforcements are piled up or by impregnating the reinforcements with excessive resin and piling up the reinforcements to form a piled body passing the piled body through the opening of a slit device, the opening of the slit of which is determined by the thickness of reinforcement, the number of the reinforcements to be piled up or the thickness of the resin layer located between the reinforcements, and curing the piled body or laminate by heating. When producing laminates by impregnating reinforcements with a thermosetting liquid resin without using a solvent, and by curing the laminated reinforcements, it is desirable that no substantial pressure is applied to the laminated reinforcements for molding the laminates. The reason why no substantial pressure should be applied is that the quantity of resin existing between layers of reinforcements can be controlled by passing several reinforcements through the slit device, and that the desired construction of the laminate can be obtained by curing without applying pressure. It is well known that a thermosetting resin impregnating a reinforcement contracts somewhat during the curing process in the reinforcement. Therefore a small vacant space between layers of reinforcements impregnated with resin happens to be produced because of the contraction of the resin during the curing process without applying pressure.

The invention prevents this problem of producing vacant spaces or cavities in the laminate and leads to favorable results. It is understood that a resinous liquid which exists between the layers of reinforcement compensates the contraction of the resin in the reinforcement during the curing process. The resin employed for layers 2 containing no solvent is suitable for carrying out this invention because the resin needs not to be dried to evaporate the solvent and in addition to that the thickness of the resin layer 2 between the reinforcements can be controlled without difficulty. The viscosity of the uncured liquid resin is also an important factor to control the layers 2 of resin located between the reinforcements 1. For this reason unsaturated polyester resins are desirable in this invention because uncured unsaturated polyester resins are in liquid state at room temperature and can be produced to have a wide range of viscosity, for example from 0.005 to 1.5 Pas. The thickness of the resin layer 2 is preferably 1 to 100 $\mu$m. An excessive thickness of the layer 2 is apt to harm the properties of the laminate, for example the punching quality. Therefore the thickness of the resin layer is preferably thinner than the thickness of reinforcement.

The existence and the thickness of the resin layer 2 can be examined exactly with an optical microscope by the conventional method of cutting a cross section of the laminate with a sharp knife, or by setting the test piece with an encapsulating resin and then cutting and polishing the section. For the metal clad laminates as shown in Fig. 2, aluminum or copper foils are recommended for their high electric conductivity and mechanical strength, especially an electrolytic copper foil for its strong adhesion. In this invention it is desirable to provide resin layers not only between each of the reinforcements but also on one or both sides of the laminate as shown in Fig. 1. And for the metal clad laminate, the formation of the resin layer as adhesive surface as shown in Fig. 2 is also recommended.

The complete isolation of the reinforcements by the intermediate resin layers 2 is naturally desirable, however the benefit of this invention is preserved even when there is some partial contact between the reinforcements 1 of the laminates.

In the following examples laminates manufactured by different processes are compared with conventional laminates.

Example 1

The following resin composition which is liquid at room temperature is prepared:

| | |
|---|---|
| epoxy resin (product of Shell Chemical Co. by trademark Epikote 828) | 100 parts by weight |
| methyl-tetrahydre phthalic anhydride (product of Hitachi Kasei Kabushiki-kaisha by trademark HN-2200) | 80 parts |
| dimethylbenzylamine | 0,01 part |

Kraft paper cut to the proper length having a thickness of 270 $\mu$m and a weight of 150 g/m² is fully impregnated with the said resin. The resin impregnating the paper is placed on an aluminum foil having a thickness of 100 $\mu$m which is supported horizontally. The same resin is also applied on the paper which is placed on the aluminum foil to form a resin layer having a thickness of 1 mm. Another virgin paper is placed on the layer resin to have the resin impregnating up into the virgin paper. Said virgin paper is again coated with the same resin composition as defined above. In the same manner the procedure of placing virgin paper on the resin coated paper and coating it with the liquid resin composition is repeated. Finally a pile of six papers being impregnated with the liquid resin composition is produced. After applying the liquid resin composition to the top of the pile and placing an aluminum foil having a thickness of 100 $\mu$m on it, the pile is forced to pass through a pair of rollers. The clearance between the rollers is adjusted to 1800 $\mu$m. By curing the pile in a hot blast of 150°C for 60 minutes, under low pressure or substantially no pressure, and by removing the aluminum foil thereafter, an insulating laminate having a thickness of 1.6 mm is produced. In the laminate thus obtained, resin layers with a thickness of about 20 $\mu$m are detected between the paper reinforcement.

Comparative test 1

A liquid resin composition is applied on a paper which is the same kind of paper being used in Example 1 by curtainflow method so as to leave 50% of resin on the paper. Seven sheets of paper impregnated with the resin are piled up and aluminum foils with a thickness of 100 $\mu$m are placed on both sides of the pile. The pile is forced to pass through a pair of rollers having clearance of 1800 $\mu$m. By performing the same process as that disclosed in Example 1, the pile is cured and an insulating laminate with a thickness of 1,6 mm is produced. This laminate does not have substantial layers of resin between the reinforcements.

Example 2

A liquid resin composition is prepared by blending 100 parts by weight of commercialized unsaturated polyester resin (product of Takeda Pharmaceutical Co. by trademark Polymal 6304) and one part by weight of Cumene hydro peroxide.

The unsaturated polyester has following property:

| | |
|---|---|
| specific weight of liquid | 1.1 g/cm³ |
| viscosity at 25°C about | 0.45 Pas |
| specific weight of solid | 1.2 g/cm³ |
| heat distortion temperature of solid | 90°C |
| bending strength of solid | 11.2 kg/mm² |
| moduls of bending elasticity of solid | 440 kg/mm² |
| Vicat hardness of solid | 45 |

In the same manner as that of Example 1 papers impregnated with the resin composition are piled up and on one surface of the pile an electrolytic copper foil having a thickness of 35 $\mu$m is placed. The pile is forced to pass through a pair of rollers being adjusted to a clearance of 1730 $\mu$m, cured in a heat blast first at a temperature of 100°C for 30 minutes and then at 85°C for 10 hours, whereafter the aluminum foil on one side of pile is removed. The copper clad laminate thus obtained has a thickness of about 1.6 mm and comprises layers of resin with a thickness of 20 $\mu$m between each of the paper reinforcements.

Comparative test 2

The liquid resin composition prepared according to Example 2 is applied on the paper of the same kind used in Example 1 by a curtain-flow method to leave 53% of resin impregnating the paper. Seven sheets of paper impregnated with the resin composition are piled up without applying resin liquid between them, and on one side of the pile an aluminum foil having a thickness of 100 $\mu$m is placed and on the other side of the pile an electrolytic copper foil with a thickness of 35 $\mu$m is placed. Then the pile is forced to pass through a pair of rollers having a clearance of 1730 $\mu$m and cured in the same manner as described in Example 2. The copper clad laminate thus obtained has a thickness of about 1,6 mm and does not comprise layers of resin between the reinforcements.

In the following table the features of the Examples and comparative tests are presented. The test is performed by the method defined in JIS—C—6481.

The bracketed data in the table indicate the condition of pretreatment of the test pieces. From the table it is clear that all Examples of the present invention show a clear advance over the comparative tests.

| | Example 1 | Comparative test 1 | Example 2 | Comparative test 2 |
|---|---|---|---|---|
| ratio of soaking water (%) | 1,0 | 2,3 | 1,2 | 2,5 |
| ratio of absorbing moisture (%) (C-96/40/95) | 2,2 | 3,5 | 2,3 | 3,8 |
| ratio of mass resistance ($\Omega$-cm) (C-96/23/65) | $7 \times 10^{13}$ | $2 \times 10^{13}$ | $9 \times 10^{13}$ | $8 \times 10^{13}$ |
| ratio of mass resistance ($\Omega$-cm) (C-96/40/95) | $1 \times 10^{10}$ | $4 \times 10^{8}$ | $8 \times 10^{12}$ | $6 \times 10^{7}$ |
| heat resistance to solder (s) (C-96/23/65) | 26 | 18 | 30 | 23 |
| heat resistance to solder (s) (C-96/40/95) | 8 | 2 | 3 | 1 |

## Claims

1. A process for producing insulating laminates and metal clad laminates for electric use by laminating a plurality of reinforcements impregnated with a curable resin, characterized by impregnating each of said reinforcements with a liquid curable resin without using a solvent and applying the same liquid curable resin to the surface of the impregnating reinforcements or impregnating each of said reinforcements with excessive liquid curable resin; forming a piled body of said reinforcements; passing said piled body through a slit device to control the quantity of resin existing between the layers of reinforcements; and curing the laminate; thereby providing a laminate comprising layers of cured resin existing between and extending substantially over the reinforcements.

2. The process according to claim 1, characterized by using electrolytic copper foil for producing a metal clad laminate.

3. The process as defined in claim 1, characterized in that the reinforcements consist of paper containing predominantly cellulose fibers.

4. The process according to claim 1, characterized in that the curable resin in an unsaturated polyester resin.

## Patentansprüche

1. Verfahren zur Herstellung von isolierenden Laminaten und metallbeschichteten Laminaten für elektrische Anwendungen durch Laminieren einer Veilzahl von mit einem härtbaren Harz imprägnierten Verstärkungsschichten, dadurch gekennzeichnet, daß man jede der Verstärkungsschichten mit einem flüssigen härtbaren Harz ohne die Verwendung eines Lösungsmittels imprägniert und das gleiche flüssige härtbare Harz auf die Oberfläche der imprägnierten Verstärkungsschichten aufbringt oder die Verstärkungsschichten jeweils mit überschüssigem flüssigem härtbarem Harz imprägniert; einen aufgestapelten Körper aus den Verstärkungsschichten bildet; den aufgestapelten Körper zur Steuerung der Menge des zwischen den Verstärkungsschichten vorliegenden Harzes durch eine Schlitzeinrichtung führt; und das Laminat aushärtet unter Bildung eines Laminats, welches ausgehärtete Harzschichten aufweist, die sich zwischen und im wesentlichen über die Verstärkungsschichten erstrecken.

2. Verfahren nach Anspruch 1, dadurch gekennzeichnet, daß man elektrolytische Kupferfolie zur Bildung eines metallbeschichteten Laminats verwendet.

3. Verfahren nach Anspruch 1, dadurch gekennzeichnet, daß die Verstärkungsschichten aus Papier, welches überwiegend Cellulosefasern enthält, bestehen.

4. Verfahren nach Anspruch 1, dadurch gekennzeichnet, daß das härtbare Harz ein ungesättigtes Polyesterharz ist.

## Revendications

1. Procédé de fabrication de stratifiés isolants et de stratifiés à revêtement métallique pour usage électrique par superposition d'une pluralité d'armatures imprégnées avec une résine durcissable, caractérisé par le fait qu'on imprègne chacune desdites armatures avec une résine liquide durcissable sans utiliser de solvant, et qu'on applique la même résine liquide durcissable sur la surface de l'imprégnation des armatures ou qu'on imprègne chacune desdites armatures avec un excès de résine liquide durcissable; on forme un bloc empilé desdites armatures; on fait passer ledit bloc empilé à travers un dispositif à fente pour régler la quantité de résine existant entre les couches d'armatures; et on durcit le stratifié, obtenant ainsi un stratifié comprenant des couches de résine durcie existant entre les armatures et s'étendant sensiblement sur celles-ci.

2. Procédé selon la revendication 1, caractérisé par le fait qu'on utilise une feuille de cuivre électrolytique pour obtenir un stratifié à revêtement métallique.

3. Procédé selon la revendication 1, caractérisé par le fait que les armatures sont constituées par du papier contenant principalement des fibres cellulosiques.

4. Procédé selon la revendication 1, caractérisé par le fait que la résine durcissable est une résine de polyester insaturée.

FIG.1

FIG.2

FIG.3

FIG.4